# EUROPEAN PATENT SPECIFICATION

(11) **EP 3 267 776 B1**
(45) Date of publication and mention of the grant of the patent: **30.12.2020**
(21) Application number: 15883883.9
(22) Date of filing: 02.03.2015
(51) Int. Cl.: H05K 13/02, H05K 13/04, H05K 13/08

(54) **FEEDER CONTROL DEVICE, CONTROL METHOD, AND COMPONENT MOUNTING DEVICE**
ZUFÜHRERSTEUERUNGSVERFAHREN, STEUERUNGSVERFAHREN UND KOMPONENTENMONTAGEVORRICHTUNG
DISPOSITIF DE COMMANDE D'APPORT, PROCÉDÉ DE COMMANDE ET DISPOSITIF DE MONTAGE DE COMPOSANT

(43) Date of publication of application: 10.01.2018
(73) Proprietor: FUJI Corporation, Chiryu Aichi (JP)
(72) Inventor: SUGIMOTO Koichiro, Chiryu Aichi (JP); TAKAHASHI Akira, Chiryu Aichi (JP)
(74) Representative: Grünecker Patent- und Rechtsanwälte PartG mbB
(86) International application number: PCT/JP2015/056062
(87) International publication number: WO 2016/139713

(56) References cited:
- JP-A- H1 126 985
- JP-A- 2011 077 096
- JP-A- 2015 028 970
- US-A- 6 047 874
- US-A1- 2015 039 115

## Description

### Technical Field

The present invention relates to a feeder control device, control method, and a component mounting apparatus which can automatically discharge a carrier tape which accommodates a component type not to be used in production of a next board type therein when board types to be produced are switched.

### Background Art

In PTL 1 and PTL 2, a feeder which can automatically convey a carrier tape to a suction position at which a component is suctioned without performing splicing processing, is described, splicing work due to component shortage becomes unnecessary by using the feeder, and there is no case where a component mounting apparatus is stopped by the splicing.

Similar feeder control devices are disclosed in US-2015-039115 A1 (PTL 3) and US-6-047-874 A1 (PTL 4).

### Citation List

### Patent Literature

PTL 1: JP-T-2010-507908
PTL 2: JP-A-2011-77096
PTL 3: US-2015-039115 A1
PTL 4: US-6-047-874 A1

### Summary of Invention

### Technical Problem

In general, a feeder of a component mounting apparatus is mounted to be attachable to and detachable from multiple slots provided in a component supply device, and the feeder on which a carrier tape which accommodates a predetermined component type therein is loaded can be mounted on a predetermined slot when necessary. Therefore, for example, when production of a certain board type is finished and production of the next board type is started, setup changing work of detaching the feeder on which a component type used in the production of the certain board type is loaded from the slot, and mounting the feeder on which a component type to be used in the production of the next board type is loaded onto the slot, is performed. When the setup changing work takes a lot of time, a stopping time of the component mounting apparatus becomes longer and an operating ratio of the apparatus deteriorates.

Considering the above-described problem, an object of the invention is to provide a feeder control device, control method, and a component mounting apparatus which can automatically discharge an unnecessary carrier tape without detaching the feeder when board types to be produced are switched.

### Solution to Problem

In order to solve the above-described problem, there is provided a feeder control device in a component mounting apparatus of the invention including a control device which automatically discharges a carrier tape that accommodates a component type to be mounted on a board type to a tape insertion port based on a component discharge instruction, and automatically conveys an inserted carrier tape to a suction position at which a component is suctioned when the carrier tape is inserted into the tape insertion port, in which the control device includes a component determination section which determines a component type not to be used in production of the next board type when board types to be produced by the component mounting apparatus are switched, and a discharge instruction section which sends an instruction of discharging a carrier tape that accommodates the component type determined not to be used in the production of the next board type by the component determination section to the tape insertion port.

### Advantageous Effects of Invention

According to the invention, since it is possible to automatically discharge a carrier tape which accommodates a component type not to be used in the production of the next board type therein to a tape insertion port, labor and time are not required for discharging the carrier tape from the feeder, and it is possible to suppress occurrence of a human error, such as discharge of a carrier tape from a wrong feeder.

### Brief Description of Drawings

[Fig. 1] Fig. 1 is a plan view illustrating an outline of a component supply device in an appropriate component mounting apparatus according to an embodiment of the invention.
[Fig. 2] Fig. 2 is a side view illustrating an outline of a feeder mounted on the component supply device.
[Fig. 3] Fig. 3 is a top view of a carrier tape which accommodates components therein.
[Fig. 4] Fig. 4 is a side view of an appropriate feeder according to the embodiment of the invention.
[Fig. 5] Fig. 5 is a view in which a portion of Fig. 4 is enlarged.
[Fig. 6] Fig. 6 is a block diagram illustrating a control device which controls the component mounting apparatus.
[Fig. 7] Fig. 7 is a view illustrating component data stored in a RAM of the control device.
[Fig. 8] Fig. 8 is a view illustrating component arrangement data stored in the RAM of the control device.
[Fig. 9] Fig. 9 is a view illustrating a production schedule stored in the RAM of the control device.
[Fig. 10] Fig. 10 is a view illustrating a flowchart for discharging an unnecessary component type for the board type to be produced next.

### Description of Embodiments

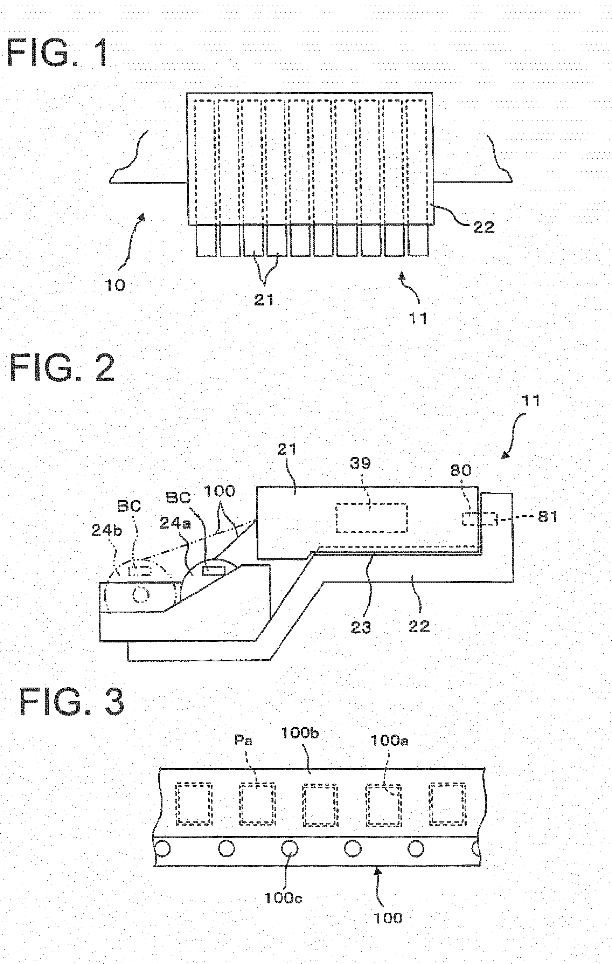

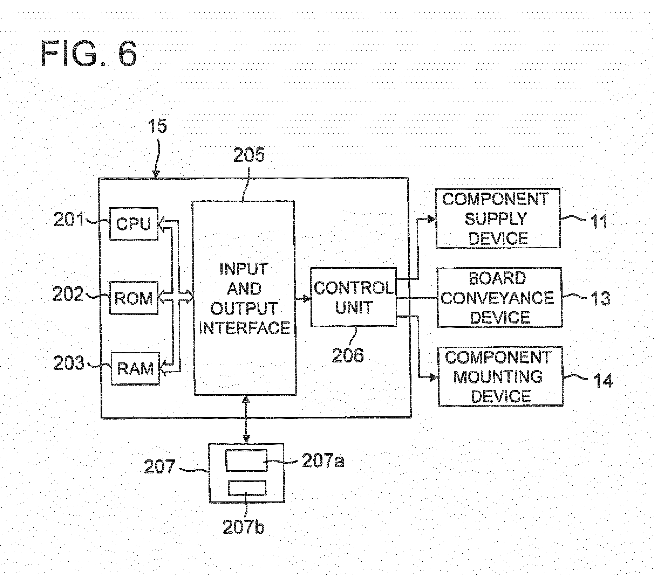

Hereinafter, an embodiment of the invention will be described based on the drawings. Fig. 1 illustrates a component mounting apparatus 10 provided with a component supply device 11. The component mounting apparatus 10 includes: a board conveyance device 13 (refer to Fig. 6) which conveys a board that is not illustrated to a component mounting position; and a component mounting device 14 (refer to Fig. 6) which has a suction nozzle that is not illustrated and suctions a component supplied by the component supply device 11, and which mounts the component suctioned by the suction nozzle onto the board.

Multiple feeders 21 are removably mounted on the component supply device 11 by being mounted on slots 23 (refer to Fig. 2) that include multiple slot positions as mounting positions provided on a feeder mounting section 22. When the feeder 21 is mounted on the slot 23, as illustrated in Fig. 2, a connector 80 provided in the feeder 21 is connected to a connector 81 attached to the feeder mounting section 22, electric power is supplied to the feeder 21 side from the main body side of the component mounting apparatus 10 via the connectors 80 and 81, and necessary information can be communicated between the feeder 21 and the component mounting apparatus 10.

Two reels 24a and 24b wound with a carrier tape 100 can be removably attached to the feeder 21. Bar codes BC which indicate information of the component types accommodated in the carrier tapes 100 wound around the reels 24a and 24b are given to the reels 24a and 24b.

As will be described later, the feeder 21 has a configuration in which it is possible to automatically convey a carrier tape 100 inserted into a tape insertion port to a suction position at which a component is suctioned, and to automatically discharge the carrier tape 100 to the tape insertion port.

As illustrated in Fig. 3, the carrier tape 100 is a tape which is formed to have component storage sections 100a that accommodate multiple components Pa, such as electronic components, therein, at a constant interval in a longitudinal direction of the tape. A cover tape 100b which covers the component storage sections 100a is attached to an upper face of the carrier tape 100. In one side section of the carrier tape 100, feeding holes 100c penetrate at a constant interval in a longitudinal direction of the tape, sprockets which will be described later are engaged with the feeding holes 100c, and the carrier tape 100 advances and retreats.

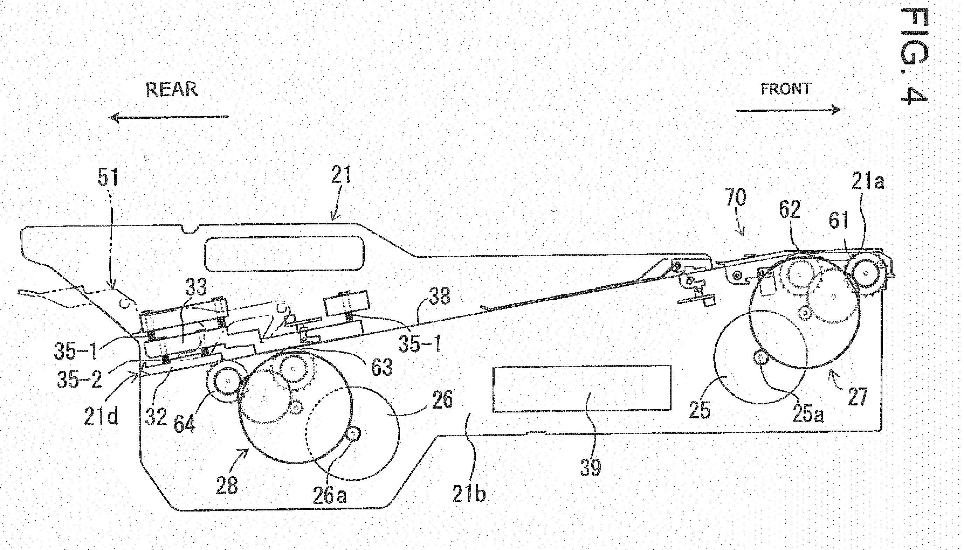

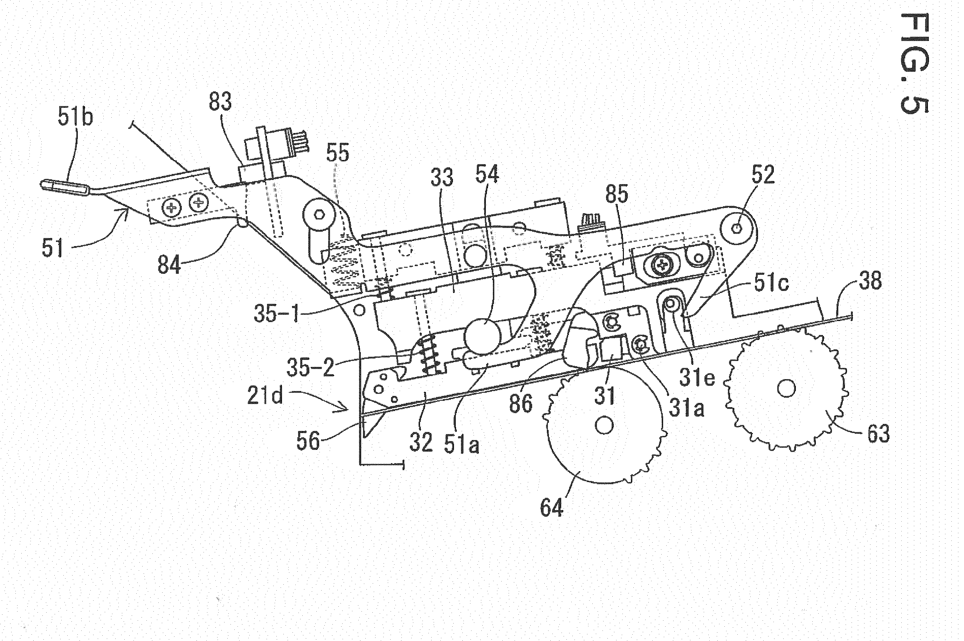

Next, a configuration of the feeder 21 will be described based on Figs. 4 and 5. The feeder 21 is mainly configured with a feeder main body 21b, a first servomotor 25, a second servomotor 26, a tape insertion recognition lever 51, a first sprocket 61 and a second sprocket 62 which function as front side sprockets, a third sprocket 63 and a fourth sprocket 64 which function as rear side sprockets, a tape conveyance rail 38, a control section 39, and a cover tape peeling device 70. In addition, Figs. 4 and 5 illustrate an inner structure of the feeder 21 to be visually seen by removing a side wall of the feeder main body 21b.

The tape conveyance rail 38 guides conveyance of the carrier tape 100, and the tape conveyance rail 38 is installed from a tape insertion port 21d provided at a rear part of the feeder main body 21b to a suction position 21a at a front part. Under the front part of the tape conveyance rail 38, the first sprocket 61 and the second sprocket 62 which can be engaged with the feeding holes 100c of the carrier tape 100 are provided to be rotatable. Under the rear part of the tape conveyance rail 38, the third sprocket 63 and the fourth sprocket 64 which can be engaged with the feeding holes 100c of the carrier tape 100 are provided to be rotatable. In addition, in the tape conveyance rail 38, a window hole (not illustrated) is provided such that each of the sprockets 61 to 64 can be engaged with the carrier tape 100 that is conveyed in the tape conveyance rail 38.

The first servomotor 25 is a motor which rotates the first sprocket 61 and the second sprocket 62. A rotating shaft 25a of the first servomotor 25 is linked to the first sprocket 61 and the second sprocket 62 via a gear mechanism 27. The second servomotor 26 is a motor which rotates the third sprocket 63 and the fourth sprocket 64. A rotating shaft 26a of the second servomotor 26 is linked to the third sprocket 63 and the fourth sprocket 64 via a gear mechanism 28. A tape driving device is configured with the first and second servomotors 25 and 26.

An inlet pressing member 32 is provided to be disposed along an upper face of the rear part of the tape conveyance rail 38 being close to the tape insertion port 21d, and to be vertically movable to be capable of being separated from and in contact with the tape conveyance rail 38. The inlet pressing member 32 is pressed downward by a spring 35-2, and usually, comes into contact with an upper face of the tape conveyance rail 38. A downstream side pressing member 33 presses the carrier tape 100 on the downstream side of the inlet pressing member 32, and is provided to be vertically movable to be capable of being separated from and in contact with the tape conveyance rail 38. The downstream side pressing member 33 is pressed downward by a spring 35-1, and usually, comes into contact with the upper face of the tape conveyance rail 38.

At the rear part of the feeder main body 21b, as illustrated in Fig. 5, the front part of the tape insertion recognition lever 51 is supported by a pivot 52, and is swingable. At a center part of the tape insertion recognition lever 51, an operation engaging section 51a which is engaged with a lower face of an engagement member 54 provided in the inlet pressing member 32, is formed. The tape insertion recognition lever 51 is swung in a counterclockwise direction of Fig. 5 by a biasing force of a spring 55, and usually, is held at a position at which the operation engaging section 51a is lowered, and makes the inlet pressing member 32 abut against the tape conveyance rail 38 by a biasing force of the spring 35-2. According to this, usually, the tape insertion port 21d is blocked by a baffle plate 56 which is pivotally supported by the rear part of the inlet pressing member 32, and the carrier tape 100 cannot be inserted into the tape insertion port 21d.

Meanwhile, when an operation knob 51b provided at a rear end of the tape insertion recognition lever 51 is raised up by an operator, and the tape insertion recognition lever 51 is swung against the biasing force of the spring 55, the inlet pressing member 32 is raised against the biasing force of the spring 35-2 by the operation engaging section 51a. Accordingly, the inlet pressing member 32 is separated from an upper part of the tape conveyance rail 38, the tape insertion port 21d is open, and the carrier tape 100 can be inserted.

A recognition sensor 83 which can recognize that the tape insertion recognition lever 51 is swung, that is, that the carrier tape 100 can be inserted, is attached to the feeder main body 21b. The recognition sensor 83 turns ON by a dog 84 attached to the tape insertion recognition lever 51.

A stopper member 31 is provided to be adjacent to the downstream side of the inlet pressing member 32. The stopper member 31 is swingable while a shaft support section 31a provided at the intermediate part thereof is pivotally supported by the downstream side pressing member 33.

At the front part of the tape insertion recognition lever 51, an actuating section 51c which can be engaged with an engaging section 31e provided at the front part of the stopper member 31, is formed, and when the tape insertion recognition lever 51 is swung against the biasing force of the spring 55, the engaging section 31e of the stopper member 31 is engaged with the actuating section 51c. Accordingly, the stopper member 31 is swung in the counterclockwise direction of Fig. 5 around the shaft support section 31a against biasing force of a spring which is not illustrated, and a rear end part of the stopper member 31 abuts against the tape conveyance rail 38. In addition, the rear end part of the stopper member 31 is usually separated from the tape conveyance rail 38 such that the carrier tape 100 can be inserted.

A dog 86 which operates a tape detection sensor 85 is pivotally supported by the downstream side pressing member 33 . When the carrier tape 100 does not exist in the tape conveyance rail 38, a tip end of the dog 86 abuts against the upper face of the tape conveyance rail 38 by biasing force of a spring which is not illustrated, but when the carrier tape 100 is inserted into the tape conveyance rail 38, the dog 86 is pushed up by the carrier tape 100 and the tape detection sensor 85 turns ON.

Next, an operation of the feeder 21 will be described. Usually, the tape insertion recognition lever 51 is held in a state illustrated in Figs. 4 and 5 by the biasing force of the spring 55, and the inlet pressing member 32 abuts against the tape conveyance rail 38 and blocks the tape insertion port 21d by the baffle plate 56.

In this state, when the operation knob 51b of the tape insertion recognition lever 51 is raised up by the operator, the inlet pressing member 32 is separated from the tape conveyance rail 38 via the operation engaging section 51a. Accordingly, the tape insertion port 21d is open, and the carrier tape 100 can be inserted. When the tape insertion recognition lever 51 is raised up, the recognition sensor 83 is operated by the dog 84, and it is recognized that the operation of the tape insertion recognition lever 51, that is, that the carrier tape 100 can be inserted. An operation signal of the recognition sensor 83 is transmitted to a control device 15 via the control section 39 of the feeder 21, and into which feeder 21 among the multiple feeders 21 is recognized the carrier tape 100 can be inserted by the control device.

In this state, by the operator, the carrier tape 100 is inserted onto the tape conveyance rail 38 through the tape insertion port 21d, and the carrier tape 100 is inserted to a predetermined position which abuts against the rear end part of the stopper member 31. Accordingly, since the dog 86 is operated by the carrier tape 100, the tape detection sensor 85 is operated, and the insertion of the carrier tape 100 is detected.

When the insertion of the carrier tape 100 is detected and the tape insertion recognition lever 51 swings and returns to an original position, the first and second servomotors 25 and 26 which configure the tape driving device are driven, and the third and fourth sprockets 63 and 64 are rotated. Accordingly, the fourth sprocket 64 is engaged with a feeding hole 100c of the carrier tape 100, and the carrier tape 100 is conveyed to the third sprocket 63 side by the fourth sprocket 64.

In accordance with the conveyance of the carrier tape 100 by the fourth sprocket 64, the downstream side pressing member 33 is raised up against the biasing force of the spring 35-1 by the carrier tape 100, and the carrier tape 100 is conveyed between the downstream side pressing member 33 and the tape conveyance rail 38. When a feeding hole 100c of the carrier tape 100 conveyed by the fourth sprocket 64 is engaged with the third sprocket 63, the carrier tape 100 is conveyed to the second sprocket 62 side by the third sprocket 63.

When a feeding hole 100c formed in the carrier tape 100 is engaged with the second sprocket 62, the carrier tape 100 is fed to the cover tape peeling device 70 by the second sprocket 62, and the cover tape 100b which is attached to the upper face of the carrier tape 100 is peeled by the cover tape peeling device 70. In addition, when a feeding hole 100c of the carrier tape 100 is engaged with the first sprocket 61, the components accommodated in the carrier tape 100 are sequentially conveyed to the suction position 21a, and are suctioned by the suction nozzle which is not illustrated in the component mounting device 14 at the suction position 21a.

In addition, in a case where the carrier tape 100 is conveyed by the feeder 21, the carrier tape 100 raises up the front end section of the stopper member 31, and accordingly, the stopper member 31 is swung, and the rear end part of the stopper member 31 comes into contact with the upper face of the carrier tape 100.

Therefore, in this state, as described above, when the tape insertion recognition lever 51 is operated to swing (the recognition sensor 83 is ON) and the following carrier tape 100 is inserted between the upper face of the previous carrier tape 100 and the inlet pressing member 32 through the tape insertion port 21d, the tip end of the following carrier tape 100 abuts against the rear end part of the stopper member 31 and stops at this position. Therefore, further conveyance of the following carrier tape 100 is interrupted, and the following carrier tape 100 is on standby at this position.

The component supply device 11, the board conveyance device 13, and the component mounting device 14 in the component mounting apparatus 10 are controlled by the control device 15 which is illustrated in Fig. 6. The control device 15 includes a CPU 201 which functions as a central processing unit, a ROM 202 and a RAM 203 which function as a storage device, and an input and output interface 205. As well as the first and second servomotors 25 and 26 provided in each of the feeders 21 of the component supply device 11, a control unit 206 which controls each of the motors of the board conveyance device 13 and the component mounting device 14, is connected to the input and output interface 205.

In addition, an operation panel 207 which is provided with a display device 207a, such as an LCD, which functions as a display section, and an input device 207b which inputs data by an operation of a keyboard or a mouse, is connected to the input and output interface 205. In the display device 207a, when the setup in accordance with a change in board type is changed, from which feeder 21 of the component supply device 11 a component type (carrier tape 100) is discharged is displayed.

In the ROM 202, as well as a basic program for mounting the components on the board, a sequence program for controlling a sequence operation of the component mounting device 14 or the like, are accommodated. In addition, in the RAM 203, component data related to information of component types to be used in production of the board type, component arrangement data which indicates relationship between the component types and the feeders 21, or data related to a production schedule of board types, are stored.

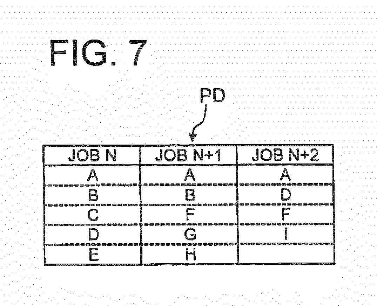

Fig. 7 illustrates component data PD which is necessary for producing the multiple board types, and thus, in Fig. 7, an example in which production of boards in which component types A, B, C, D, and E are used is performed in the production (hereinafter, referred to as a production job N) of the boards of the board type to be produced first, production of boards in which component types A, B, F, G, and H are used is performed in the production (hereinafter, referred to as a production job N + 1) of the boards of the board type to be produced secondarily, and production of boards in which component types A, D, F, and I are used is performed in the production (hereinafter, referred to as a production job N + 2) of the boards of the board type to be produced thirdly, is illustrated.

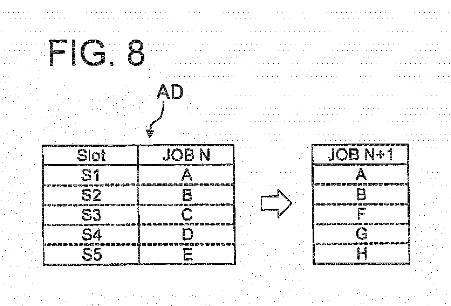

Fig. 8 illustrates component arrangement data AD, and thus, in Fig. 8, an example in which the feeder 21 having the component type A loaded thereon is mounted at a first slot position S1 ot the slot 23 of the component supply device 11, the feeder 21 having the component type B loaded thereon is mounted at a second slot position S2, and similarly, the feeder 21 having the component type C loaded thereon is mounted at a third slot position S3, the feeder 21 having the component type D loaded thereon is mounted at a fourth slot position S4, and the feeder 21 having the component type E loaded thereon is mounted at a fifth slot position S5, in the production job N, is illustrated.

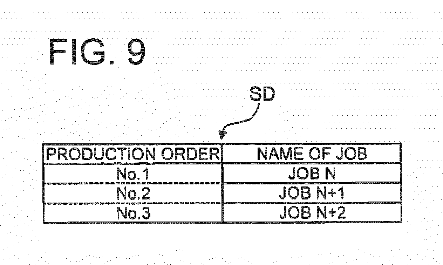

Fig. 9 illustrates production plan data SD, and thus, in Fig. 9, an example in which, first, the production job N is executed, then, the production job N + 1 is executed, and lastly, the production job N + 2 is executed, is illustrated.

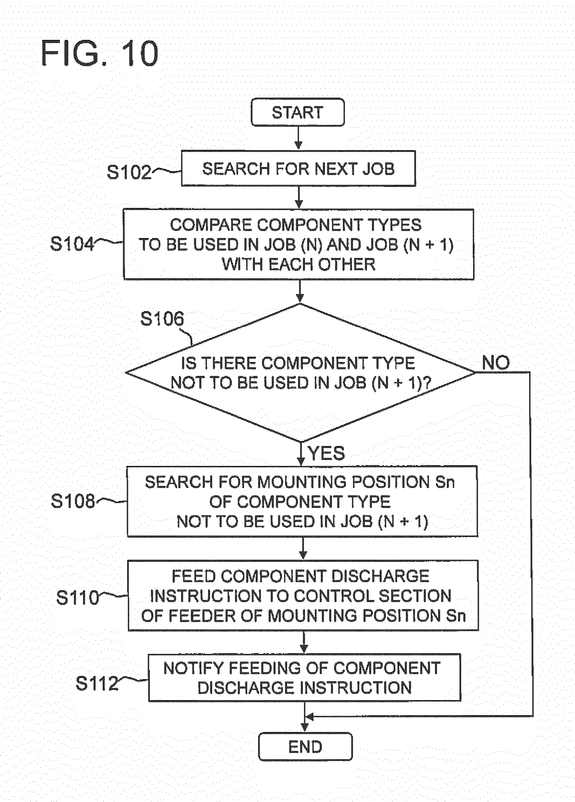

Fig. 10 illustrates a flowchart which is executed by the CPU 201 for automatically discharging a component type unnecessary in the board type to be produced next when the setup is changed when the board types to be produced are changed. Hereinafter, procedure in which the initial production job N is finished, and setup changing is performed in the next production job N + 1 based on the production plan data SD, will be described.

In addition, when the production job N is executed, as can be apparent from Fig. 8, the feeder 21 having the component type A loaded thereon is mounted at the first slot position S1 of the slot 23 of the component supply device 11, the feeder 21 having the component type B loaded thereon is mounted at the second slot position S2, and similarly, the feeder 21 having the component type C loaded thereon is mounted at the third slot position S3, the feeder 21 having the component type D loaded thereon is mounted at the fourth slot position S4, and the feeder 21 having the component type E loaded thereon is mounted at the fifth slot position S5.

In this state, when the initial production job N is finished and a setup instruction is issued, the control device 15 refers to the production plan data SD illustrated in Fig. 9 stored in the RAM 203, and searches for the production job N + 1 to be executed next in step S102. Next, in step S104, the control device 15 compares the component types to be respectively used in the production job N and the next production job N + 1 with each other based on the component data PD (refer to Fig. 7) stored in the RAM 203. Next, in step S106, the control device 15 determines whether or not there is a component type not to be used in the next production job N + 1 among the component types used in the production job N.

In a case where the determination result in step S106 is YES, that is, in a case where the control device 15 determines that there is a component type not to be used in the next production job N + 1, the process moves to step S108, and in a case where the determination result in step S106 is NO, the program is finished.

In step S108, the control device 15 searches for a mounting position of the component type not to be used, that is, a slot position Sn (n = 1 to 5) of the feeder 21 having the component type not to be used which is loaded thereon, based on the component arrangement data AD (refer to Fig. 8) stored in the RAM 203. Next, in step S110, the control device 15 instructs the discharge of the components to the feeder 21 of the slot position Sn at which the component type not to be used in the next production job N + 1 is loaded.

For example, as illustrated in Fig. 7, when the component types to be used in the production job N are A to E and the component types to be used in the next production job N + 1 are A, B, and F to H, the component types not to be used in the next production job N + 1 are C to E, and the slot positions at which the component types C to E are loaded are S3 to S5 according to the component arrangement data AD illustrated in Fig 8.

Therefore, the control device 15 sends the discharge instruction of the components to the control section 39 of each of the feeders 21 mounted at the slot positions S3 to S5. Based on the component discharge instruction, the first and second servomotors 25 and 26 which configure the tape driving device are respectively driven to be reversely rotated by the control section 39 of each of the feeders 21 mounted at the slot positions S3 to S5. Accordingly, the carrier tapes 100 loaded on each of the feeders 21 retreats toward the tape insertion port 21d. In addition, when the end section of the carrier tape 100 retreats to the predetermined position which passes through the dog 86, the dog 86 is swung, the tape detection sensor 85 turns OFF, and thus, the first and second servomotors 25 and 26 are stopped by a signal change of the tape detection sensor 85.

Next, in step S112, the control device 15 displays that the component discharge instruction is sent to each of the feeders 21 mounted at the slot positions S3 to S5 in the display device 207a of the operation panel 207, and notifies this to the operator. Based on the notification, the operator pulls out the carrier tape 100 discharged to the tape insertion port 21d, and detaches the reel 24a (24b) wound around the carrier tape 100 from the feeder 21.

The above-described step S106 configures a component determination section which determines a component type not to be used in the production of the next board type when the production of the board produced by the component mounting apparatus 10 is switched. In addition, the above-described step S110 configures a discharge instruction section which sends the instruction of discharging the carrier tape 100 which accommodates a component type determined not to be used in the production of the next board type by the component determination section (step S106) therein, to the tape insertion port 21d.

In this manner, by automatically discharging the carrier tape 100 which accommodates a component type not to be used in the production of the next board type therein, labor and time are not required for discharging the carrier tape 100 from the feeder 21, and the setup changing work becomes easy. Besides, it is also possible to suppress occurrence of a human error of discharging a carrier tape 100 from a wrong feeder 21.

Moreover, in a state where the feeder 21 remains fixed to the feeder mounting section 22 of the component supply device 11, only the components (carrier tape 100) may be exchanged, and thus, it is possible to substantially shorten the time for setup changing.

In addition, when the feeder 21 having the above-described configuration is used, it is possible to insert the carrier tape 100 which accommodates a component type to be used in the production of the next board type therein into the empty feeder 21 through which the carrier tape 100 has just been discharged, and thus, it is also possible to reduce the number of feeders 21.

In other words, the component type to be used newly in the production job N + 1 is searched based on the component data PD in Fig. 7 and the production plan data SD in Fig. 9, and the component types are displayed in the display device 207a of the operation panel 207 of the control device 15. The operator prepares the reels 24a (24b) around which the carrier tapes 100 which accommodate the component types F to H to be used newly in the production job N + 1 therein are wound, and mounts the reels 24a (24b) on the feeders 21, based on the display contents of the display device 207a. After this, when the operator opens the tape insertion port 21d by operating the tape insertion recognition lever 51 and inserts the carrier tape 100 into the tape insertion port 21d, the first and second servomotors 25 and 26 which configure the tape driving device are driven to be forwardly rotated. Accordingly, the carrier tape 100 advances, and the components accommodated in the carrier tape 100 are automatically conveyed to the suction position 21a at which the components are suctioned by the suction nozzle which is not illustrated.

In this case, before mounting the reel 24a (24b) onto the feeder 21, by reading the bar code BC given to the reel 24a (24b) by a reading device which is not illustrated, and by ascertaining the information of the component type, association between the slot position Sn at which the feeder 21 is mounted and the information of the component type is performed. In other words, the component arrangement data AD stored in the RAM 203 is rewritten to the contents that the component types F to H are loaded on each of the feeders 21 at the slot positions S3 to S5 at which the component types C to E are mounted (refer to the arrow in Fig. 8).

In the above-described embodiment, when the production of the board type is switched, the carrier tape 100 which accommodates a component type not to be used in the production of the next board type therein is automatically discharged to the tape insertion port 21d, but by continuously monitoring a use plan of component types accommodated in the carrier tapes 100 by the control device 15, when it is determined that there is no use plan (when it is determined that the component type will not be used in the production of the next board type), even in the middle of the production of the board, it is possible to send the component discharge instruction of discharging the carrier tape 100 which accommodates the component type planned not to be used therein to the tape insertion port 21d. Accordingly, before the production of the board type is switched, it is possible to send the instruction of discharging the carrier tape 100 which accommodates a component type not to be used in the production of the next board type therein to the tape insertion port 21d.

According to the above-described embodiment, the control device 15 of the component mounting apparatus 10 includes a component determination section S106 which determines a component type not to be used in the production of the next board type when the production of the board type to be produced by the component mounting apparatus 10 is switched, and a discharge instruction section S110 which sends the instruction of discharging the carrier tape 100 which accommodates the component type determined not to be used in the production of the next board type therein by the component determination section S106 to the tape insertion port 21d.

Accordingly, since it is possible to automatically discharge the carrier tape 100 which accommodates a component type not to be used in the production of the next board type therein to the tape insertion port 21d, labor and time are not required for discharging the carrier tape 100 from the feeder 21, and it is possible to suppress occurrence of a human error, such as discharge of a carrier tape 100 from a wrong feeder 21.

In addition, while the feeder 21 remains fixed to the feeder mounting section 22, only the components (carrier tape 100) may be discharged from the feeder 21, and thus, the setup changing work becomes easy. Moreover, since the carrier tape 100 which accommodates a component type to be used in the production of the next board type therein can be inserted into the feeder 21 through which the carrier tape 100 has just been discharged, it is also possible to reduce the number of feeders 21.

According to the above-described embodiment, since the control device 15 of the component mounting apparatus 10 includes the display device 207a which notifies the component discharge instruction after the component discharge instruction is issued, the operator can easily ascertain from which feeder 21 the carrier tape 100 is discharged based on the contents displayed in the display device 207a.

According to the above-described embodiment, since a method for determining a component type not to be used in the production of the next board type and discharging the carrier tape 100 which accommodates the component type therein to the tape insertion port 21d when the production of the board type to be produced by the component mounting apparatus 10 is switched is employed, it is possible to automatically discharge the carrier tape 100 which accommodates a component type not to be used in the production of the next board type therein to the tape insertion port 21d. Accordingly, labor and time are not required for discharging the carrier tape 100 from the feeder 21, and it is possible to suppress occurrence of a human error, such as discharge of a carrier tape 100 from a wrong feeder 21.

According to the above-described embodiment, each of the feeders 21 of the component supply device 11 includes the control section 39 which controls the tape driving device (first and second servomotors 25 and 26) which drives the carrier tape 100, the component mounting apparatus 10 includes the control device 15 which instructs the discharge or the supply of the component Pa with respect to each of the control sections 39, the control device 15 determines a component type not to be used in the production of the next board type with respect to the control section 39 when the production of the board type is switched, and sends the instruction of discharging the carrier tape 100 which accommodates the component type therein to the tape insertion port 21d.

Accordingly, since the instruction of discharging the carrier tape 100 which accommodates the component type not to be used in the production of the next board type therein to the tape insertion port 21d, is sent to each of the control sections 39 of the feeders 21 by the control device 15 when the production of the board type is switched, it is possible to automatically discharge the carrier tape 100 which accommodates a component type not to be used in the production of the next board type therein to the tape insertion port 21d. Accordingly, the component mounting apparatus 10 in which labor and time are not required for discharging the carrier tape 100 from the feeder 21, and it is possible to suppress occurrence of a human error, such as discharge of a carrier tape 100 from a wrong feeder 21, can be obtained.

According to the above-described embodiment, when the control device 15 constantly monitors the use plan of component types accommodated in the carrier tapes 100 and determines that there is no use plan, the control device 15 sends the component discharge instruction of discharging the carrier tape 100 which accommodates the component type therein to the tape insertion port 21d. Accordingly, before the production of the board is switched, it is possible to send the instruction of discharging the carrier tape 100 which accommodates the component type not to be used in the production of the next board type therein to the tape insertion port 21d.

In the above-described embodiment, the feeder 21 into which the two carrier tapes 100 can be inserted and discharged is described, but the invention can also be employed in the feeder 21 into which only one carrier tape 100 can be automatically inserted and discharged, and in this case, the configuration of the stopper member 31 which makes the following carrier tape 100 on standby or the downstream side pressing member 33 can be unnecessary.

In addition, in the above-described embodiment, the feeder 21 including the sprockets 61 and 62, and 63 and 64 two by two on each of the front side and rear side, is described, but the feeder 21 described in the embodiment is merely one appropriate example of the invention. In other words, at least, the feeder 21 which can automatically convey the carrier tape 100 inserted into the tape insertion port 21d to the suction position 21a at which a component is suctioned, and can automatically discharge the carrier tape 100 to the tape insertion port 21d, may be employed.

Furthermore, in the above-described embodiment, an example in which the display section which notifies the component discharge instruction is configured with the display device 207a of the operation panel 207, is described, but the display section can be configured with lamps provided corresponding to each of the slots 23. In other words, information to which feeder 21 the component discharge instruction is sent may be notified to the operator by turning on the lamp.

In addition, the setup changing in the above-described embodiment can also be employed in a case of producing one or a predetermined number of boards.

In this manner, the invention is not limited to the configuration described in the above-described embodiment, and various aspects can be employed within the range that does not depart from the main idea of the invention described in the range of the claims.

### Industrial Applicability

The feeder control device and control method and the component mounting apparatus according to the invention are appropriate for a device which uses a feeder having a configuration in which the carrier tape inserted into the tape insertion port can be automatically conveyed to the suction position at which a component is suctioned, and can be automatically discharged to the tape insertion port.

### Reference Signs List

10 ... component mounting apparatus, 11 ... component supply device, 15 ... control device, 21 ... feeder, 21a ... suction position, 21d ... tape insertion port, 22 ... feeder mounting section, 23 ... mounting position (slot), 25, 26 ... tape driving device (servomotor), 39 ... control section, 61 to 64 ... sprocket, 83 ... recognition sensor, 100 ... carrier tape, 207a ... display section (display device), S106 ... component determination section, S110 ... discharge instruction section

## Claims

1. A feeder control device configured to be used in a component mounting apparatus (10) including a control device (15) which automatically discharges a carrier tape (100) that accommodates a component type to be mounted on a board type to a tape insertion port (21d) based on a component discharge instruction, and automatically conveys an inserted carrier tape (100) to a suction position (21a) at which a component is suctioned when the carrier tape (100) is inserted into the tape insertion port (21d),
wherein the control device (15) includes
a component determination section (S106) which determines a component type not to be used in production of the next board type when board types to be produced by the component mounting apparatus (10) are switched,
a discharge instruction section (S110) which sends an instruction of discharging a carrier tape (100) that accommodates the component type determined not to be used in the production of the next board type by the component determination section (S106) to the tape insertion port (21d), and
a RAM (203) which stores component data related to information of component types to be used in production of the board type, component arrangement data which indicates relationship between the component types and the feeders (21), or data related to a production schedule of board types.

2. The feeder control device in the component mounting apparatus (10) according to claim 1,
wherein the control device (15) includes a display section (207a) which notifies a component discharge instruction after the component discharge instruction.

3. A feeder control method for a component mounting apparatus (10) which automatically discharges a carrier tape (100) that accommodates a component type to be mounted on a board type to a tape insertion port (21d) based on a component discharge instruction, and automatically conveys an inserted carrier tape (100) to a suction position (21a) at which a component is suctioned when the carrier tape (100) is inserted into the tape insertion port (21d),
wherein, a component type not to be used in production of the next board type is determined when board types to be produced by the component mounting apparatus (10) are switched, and
the carrier tape (100) which accommodates the component type determined not to be used in the production of the next board type by the component determination section (S106) is discharged to the tape insertion port (21d), and
a component data related to information of component types to be used in production of the board type, component arrangement data which indicates relationship between the component types and the feeders (21), or data related to a production schedule of board types is stored.

4. A component mounting apparatus (10) comprising the feeder control device according to claims 1 to 2 and a component supply device (11), wherein the carrier tape (100) accommodates the component type to be mounted on the board type in which the plurality of feeders (21) having carrier tapes (100) loaded are respectively mounted at a plurality of mounting positions (23), which automatically discharges a carrier tape (100) to a tape insertion port (21d) of the feeder (21) based on the component discharge instruction, and which automatically conveys an inserted carrier tape (100) to the suction position (21a) at which the component is suctioned when the carrier tape (100) is inserted into the tape insertion port (21d),
wherein each of the feeders (21) of the component supply device (11) includes a control section (39) which controls a tape driving device (25, 26) that drives a carrier tape (100),
wherein the control device (15) instructs discharge or supply of a component with respect to each of the control sections (39), and
wherein the control device (15) sends an instruction of determining a component type not to be used in the production of the next board type, and discharging the carrier tape (100) that accommodates the component type to the tape insertion port (21d), with respect to the control section (39) when the production of the board type is switched.

5. A component mounting apparatus (10) comprising the feeder control device according to claims 1 to 2 and a component supply device (11), wherein the carrier tape (100) accommodates the component type to be mounted on the board type in which the plurality of feeders (21) having carrier tapes (100) loaded are respectively mounted at the plurality of mounting positions (23), which automatically discharges a carrier tape (100) to a tape insertion port (21d) of the feeder (21) based on the component discharge instruction, and which automatically conveys an inserted carrier tape (100) to the suction position (21a) at which the component is suctioned when the carrier tape (100) is inserted into the tape insertion port (21d),
wherein the control device (15) constantly monitors the use plan of a component type accommodated in a carrier tape (100) and sends the component discharge instruction of discharging the carrier tape (100) which accommodates the component type to the tape insertion port (21d) when it is determined that the component type is not planned to be used.

## Patentansprüche

1. Steuerungsvorrichtung für Zuführeinrichtungen, die zum Einsatz in einer Vorrichtung (10) zum Montieren von Bauteilen ausgeführt ist, die eine Steuerungsvorrichtung (15) enthält und ein Trägerband (100), das einen auf einem Platinen-Typ zu montierenden Bauteil-Typ aufnimmt, auf Basis einer Anweisung zur Ausgabe von Bauteilen automatisch an eine Band-Einführöffnung (21d) ausgibt und ein eingeführtes Trägerband (100) automatisch zu einer Ansaug-Position (21a) transportiert, an der ein Bauteil angesaugt wird, wenn das Trägerband (100) in die Band-Einführöffnung (21d) eingeführt wird,
wobei die Steuerungsvorrichtung (15) einschließt:
einen Abschnitt (S106) für Bestimmung von Bauteilen, der einen bei Herstellung des nächsten Platinen-Typs nicht zu verwendenden Bauteil-Typ bestimmt, wenn durch die Vorrichtung (10) zum Montieren von Bauteilen herzustellende Platinen-Typen gewechselt werden, und
einen Abschnitt (S110) für Anweisung von Ausgabe, der eine Anweisung zum Ausgeben eines Trägerbandes (100), das den Bauteil-Typ, der durch den Abschnitt (S106) für Bestimmung von Bauteilen als bei der Herstellung des nächsten Platinen-Typs nicht zu verwendend bestimmt wurde, zu der Band-Einführöffnung (21d) sendet, und
einen RAM (203), der Bauteil-Daten, die sich auf Informationen über bei Herstellung des Platinen-Typs zu verwendende Bauteil-Typen beziehen, Bauteilanordnungs-Daten, die Beziehung zwischen den Bauteil-Typen und den Zuführeinrichtungen (21) angeben, oder Daten speichert, die sich auf einen Plan zur Herstellung von Platinen-Typen beziehen.

2. Steuerungsvorrichtung für Zuführeinrichtungen in der Vorrichtung (10) zum Montieren von Bauteilen nach Anspruch 1,
wobei die Steuerungsvorrichtung (15) einen Anzeigeabschnitt (207a) enthält, der nach der Anweisung zur Ausgabe von Bauteilen über eine Anweisung zur Ausgabe von Bauteilen informiert.

3. Steuerungsverfahren für Zuführeinrichtungen für eine Vorrichtung (10) zum Montieren von Bauteilen, die ein Trägerband (100), das einen auf einem Platinen-Typ zu montierenden Bauteil-Typ aufnimmt, auf Basis einer Anweisung zur Ausgabe von Bauteilen automatisch an eine Band-Einführöffnung (21d) ausgibt und ein eingeführtes Trägerband (100) automatisch zu einer Ansaug-Position (21a) transportiert, an der ein Bauteil angesaugt wird, wenn das Trägerband (100) in die Band-Einführöffnung (21d) eingeführt wird,
wobei ein bei Herstellung des nächsten Platinen-Typs nicht zu verwendender Bauteil-Typ bestimmt wird, wenn durch die Vorrichtung (10) zum Montieren von Bauteilen zu produzierende Platinen-Typen gewechselt werden, und
das Trägerband (100), das den Bauteil-Typ aufnimmt, der durch den Abschnitt (S106) für Bestimmung von Bauteilen als bei der Herstellung des nächsten Platinen-Typs nicht zu verwendend bestimmt wurde, an die Band-Einführöffnung (21d) ausgegeben wird, und
Bauteil-Daten, die sich auf Informationen über bei Herstellung des Platinen-Typs zu verwendende Bauteil-Typen beziehen, Bauteilanordnungs-Daten, die Beziehung zwischen den Bauteil-Typen und den Zuführeinrichtungen (21) angeben, oder Daten gespeichert werden, die sich auf einen Plan zur Herstellung von Platinen-Typen beziehen.

4. Vorrichtung (10) zum Montieren von Bauteilen, die die Steuerungsvorrichtung für Zuführeinrichtungen nach den Ansprüchen 1 bis 2 und eine Bauteil-Zuführvorrichtung (11) umfasst, wobei das Trägerband (100) den auf dem Platinen-Typ zu montierenden Bauteil-Typ aufnimmt, bei dem die Vielzahl von Zuführeinrichtungen (21), in die Trägerbänder (100) eingeführt sind, jeweils an einer Vielzahl von Montage-Positionen (23) montiert werden, die auf Basis der Anweisung zur Ausgabe von Bauteilen ein Trägerband (100) automatisch an eine Band-Einführöffnung (21d) der Zuführeinrichtung (21) ausgibt, und die ein eingeführtes Trägerband (100) automatisch zu der Ansaug-Position (21a) transportiert, an der das Bauteil angesaugt wird, wenn das Trägerband (100) in die Band-Einführöffnung (21d) eingeführt wird,
wobei jede der Zuführeinrichtungen (21) der Bauteil-Zuführvorrichtung (11) einen Steuerungsabschnitt (39) enthält, der eine Band-Antriebsvorrichtung (25, 26) steuert, die ein Trägerband (100) antreibt,
wobei die Steuerungsvorrichtung (15) Ausgabe oder Zufuhr eines Bauteils in Bezug auf jeden der Steuerungsabschnitte (39) anweist, und
wobei die Steuerungsvorrichtung (15) eine Anweisung zum Bestimmen eines bei der Herstellung des nächsten Platinen-Typs nicht zu verwendenden Bauteil-Typs und zum Ausgeben des Trägerbandes (100), das den Bauteil-Typ aufnimmt, an die Band-Einführöffnung (21d) in Bezug auf den Steuerungsabschnitt (39) sendet, wenn die Herstellung des Platinen-Typs umgeschaltet wird.

5. Vorrichtung (10) zum Montieren von Bauteilen, die die Steuerungsvorrichtung für Zuführeinrichtungen nach den Ansprüchen 1 bis 2 und eine Bauteil-Zuführvorrichtung (11) umfasst, wobei das Trägerband (100) den auf dem Platinen-Typ zu montierenden Bauteil-Typ aufnimmt, bei dem die Vielzahl von Zuführeinrichtungen (21), in die Trägerbänder (100) eingeführt sind, jeweils an der Vielzahl von Montage-Positionen (23) montiert werden, die auf Basis der Anweisung zur Ausgabe von Bauteilen ein Trägerband (100) automatisch an eine Band-Einführöffnung (21d) der Zuführeinrichtung (21) ausgibt, und die ein eingeführtes Trägerband (100) automatisch zu der Ansaug-Position (21a) transportiert, an der das Bauteil angesaugt wird, wenn das Trägerband (100) in die Band-Einführöffnung (21d) eingeführt wird,
wobei die Steuerungsvorrichtung (15) den Nutzungsplan eines Bauteil-Typs, der in einem Trägerband (100) aufgenommen ist, konstant überwacht und die Bauteil-Ausgabeanweisung zum Ausgeben des Trägerbandes (100), das den Bauteil-Typ aufnimmt, an die Band-Einführungsöffnung (21d) sendet, wenn festgestellt wird, dass Verwendung des Bauteil-Typs nicht geplant ist.

## Revendications

1. Dispositif de commande de système d'alimentation configuré pour être utilisé dans un appareil de montage de composants (10) incluant un dispositif de commande (15) qui éjecte automatiquement vers un orifice d'insertion de bande (21d) une bande porteuse (100) qui accueille un type de composant à monter sur un type de carte imprimée sur la base d'une instruction d'éjection de composant, et qui transporte automatiquement une bande porteuse (100) insérée vers une position d'aspiration (21a) à laquelle est aspiré un composant lorsque la bande porteuse (100) est insérée dans l'orifice d'insertion de bande (21d),
dans lequel le dispositif de commande (15) inclut :
une section de détermination de composant (S106) qui détermine un type de composant à ne pas utiliser dans la fabrication du type de carte suivant lors du basculement de types de cartes à fabriquer par l'appareil de montage de composants (10),
une section d'instruction d'éjection (S110) qui envoie une instruction d'éjection vers l'orifice d'insertion de bande (21d) d'une bande porteuse (100) qui accueille le type de composant déterminé à ne pas utiliser dans la fabrication du type de carte suivant opéré par la section de détermination de composant (S106), et
une mémoire RAM (203) qui stocke des données de composants se rapportant à des informations sur le type de composant à utiliser dans la fabrication du type de carte, des données d'agencement de composants qui indiquent la relation entre les types de composants et les systèmes d'alimentation, ou bien des données se rapportant à un programme de fabrication de types de cartes.

2. Dispositif de commande de système d'alimentation dans l'appareil de montage de composants (10) selon la revendication 1,
dans lequel le dispositif de commande (15) inclut une section d'affichage (207a) qui notifie une instruction d'éjection de composant après l'instruction d'éjection de composant.

3. Procédé de commande de système d'alimentation pour un appareil de montage de composants (10) qui éjecte automatiquement vers un orifice d'insertion de bande (21d) une bande porteuse (100) qui accueille un type de composant à monter sur un type de carte imprimée sur la base d'une instruction d'éjection de composant, et qui transporte automatiquement une bande porteuse (100) insérée vers une position d'aspiration (21a) à laquelle est aspiré un composant lorsque la bande porteuse (100) est insérée dans l'orifice d'insertion de bande (21d),
dans lequel il est déterminé un type de composant à ne pas utiliser dans la fabrication du type de carte suivant lors du basculement des types de cartes à fabriquer par l'appareil de montage de composants (10), et
la bande porteuse (100), qui accueille le type de composant qui a été déterminé à ne pas utiliser dans la fabrication du type de carte suivant par la section de détermination de composants (S106), est éjectée vers l'orifice d'insertion de bande (21d), et
sont stockées des données de composants, se rapportant à des informations sur les types de composants à utiliser dans la fabrication du type de carte, des données d'agencement de composants qui indiquent les relations entre les types de composants et les systèmes d'alimentation (21), ou bien des données se rapportant à un programme de fabrication de types de cartes.

4. Appareil de montage de composants (10) comprenant le dispositif de commande de système d'alimentation conforme aux revendications 1 à 2 et un dispositif de délivrance de composants (11), dans lequel la bande porteuse (100) accueille le type de composant à monter sur le type de carte dans lequel les différents systèmes d'alimentation (21) comportant des bandes porteuses (100) chargées sont respectivement montés au niveau d'une pluralité de positions de montage (23) ; dispositif qui éjecte automatiquement une bande porteuse (100) vers un orifice d'insertion de bande (21d) du système d'alimentation (21) sur la base de l'instruction d'éjection de composant, et qui transporte automatiquement une bande porteuse (100) insérée vers la position d'aspiration (21a) à laquelle est aspiré le composant lorsque la bande porteuse (100) est insérée dans l'orifice d'insertion de bande (21d),
dans lequel chacun des systèmes d'alimentation (21) du dispositif de délivrance de composants (11) inclut une section de commande (39) qui pilote un dispositif d'entraînement de bande (25, 26) qui entraîne une bande porteuse (100),
dans lequel le dispositif de commande (15) ordonne l'éjection ou la délivrance d'un composant par rapport à chacune des sections de commande (39), et
dans lequel le dispositif de commande (15) envoie une instruction de détermination du type de composant à ne pas utiliser dans la fabrication du type de carte suivant, et d'éjection vers l'orifice d'insertion de bande (21d) de la bande porteuse (100) qui accueille le type de composant par rapport à la section de commande (39) lors du basculement de la fabrication du type de carte.

5. Appareil de montage de composants (10) comprenant le dispositif de commande de système d'alimentation conforme aux revendications 1 à 2 et un dispositif de délivrance de composants (11), dans lequel la bande porteuse (100) accueille le type de composant à monter sur le type de carte dans lequel les différents systèmes d'alimentation (21) comportant des bandes porteuses (100) chargées sont respectivement montés au niveau d'une pluralité de positions de montage (23) ; dispositif qui éjecte automatiquement une bande porteuse (100) vers un orifice d'insertion de bande (21d) du système d'alimentation (21) sur la base de l'instruction d'éjection de composant, et qui transporte automatiquement une bande porteuse (100) insérée vers la position d'aspiration (21a) à laquelle est aspiré le composant lorsque la bande porteuse (100) est insérée dans l'orifice d'insertion de bande (21d),
dans lequel le dispositif de commande (15) surveille de manière constante le plan d'utilisation d'un type de composant logé sur une bande porteuse (100) et envoie l'instruction d'éjection de composant, indiquant d'éjecter vers l'orifice d'insertion de bande (21d) la bande porteuse (100) qui accueille le type de composant, lorsqu'il est déterminé qu'il est pas planifié d'utiliser le type de composant.
